(19) **Europäisches Patentamt**

**European Patent Office**

**Office européen des brevets**

(11) **EP 1 007 761 B1**

(12) **EUROPÄISCHE PATENTSCHRIFT**

| | |
|---|---|
| (45) Veröffentlichungstag und Bekanntmachung des Hinweises auf die Patenterteilung:<br>**07.11.2001 Patentblatt 2001/45** | (51) Int Cl.[7]: **C23C 16/40**, C23C 16/44,<br>H01L 21/316, C30B 25/14 |
| (21) Anmeldenummer: **98949888.6** | (86) Internationale Anmeldenummer:<br>**PCT/DE98/02352** |
| (22) Anmeldetag: **13.08.1998** | (87) Internationale Veröffentlichungsnummer:<br>**WO 99/09233 (25.02.1999 Gazette 1999/08)** |

(54) **GASLEITUNGSSYSTEM FÜR EINEN PROZESSREAKTOR SOWIE VERFAHREN ZUR BEHANDLUNG VON HALBLEITERSUBSTRATEN**

GAS DISTRIBUTION SYSTEM FOR A PROCESS REACTOR AND METHOD FOR PROCESSING SEMICONDUCTOR SUBSTRATES

SYSTEME DE CONDUITE DE GAZ POUR REACTEUR INDUSTRIEL ET PROCEDE DE TRAITEMENT DE SUBSTRATS A SEMI-CONDUCTEURS

| | |
|---|---|
| (84) Benannte Vertragsstaaten:<br>**DE FR GB IT** | • **OTT, Gerhard**<br>**D-92533 Wernberg-Köblitz (DE)**<br>• **MELZL, Michael**<br>**D-93055 Regensburg (DE)** |
| (30) Priorität: **14.08.1997 DE 19735399** | |
| (43) Veröffentlichungstag der Anmeldung:<br>**14.06.2000 Patentblatt 2000/24** | (74) Vertreter: **Kindermann, Peter, Dipl.-Ing.**<br>**Patentanwalt,**<br>**Postfach 1330**<br>**85627 Grasbrunn (DE)** |
| (73) Patentinhaber: **Infineon Technologies AG**<br>**81669 München (DE)** | |
| (72) Erfinder:<br>• **SCHWAIGER, Josef**<br>**D-93356 Teugn (DE)**<br>• **NIEDERHOFER, Gerhard**<br>**D-93073 Neutraubling (DE)** | (56) Entgegenhaltungen:<br>EP-A- 0 204 182    EP-A- 0 208 459<br>EP-A- 0 239 664    EP-A- 0 271 072<br>EP-A- 0 328 888    EP-A- 0 361 171<br>EP-A- 0 437 196    US-A- 5 462 899 |

**Beschreibung**

Die vorliegende Erfindung betrifft ein Gasleitungssystem für einen Prozeßreaktor, insbesondere einen Horizontal- oder Vertikalofen zur Behandlung von Wafern. Weiterhin betrifft die Erfindung einen Vertikalofen insbesondere zur Behandlung von Wafern. Schließlich betrifft die Erfindung auch ein Verfahren zur Behandlung von Wafern, insbesondere zur Abscheidung einer As-dotierten $SiO_2$-Schicht auf den Wafern.

Ein bedeutendes Verfahren in der Siliziumtechnologie ist das CVD-Verfahren (CVD = Chemical Vapour Deposition), bei dem mittels Gasphasenabscheidung Schichten wie beispielsweise $SiO_2$-Schichten oder dotierte $SiO_2$-Schichten erzeugt werden können. Das CVD-Grundprinzip besteht darin, daß ausgewählte Gase über in einem Prozeßreaktor befindliche Substrate, beispielsweise Wafer geleitet werden, auf denen eine gewünschte Schicht abgeschieden werden soll. Auf der heißen-Substratoberfläche kommt es zu einer Reaktion der Prozeßgase, so daß als Reaktionsprodukte die gewünschte Schicht sowie Gase entstehen, die aus dem Prozeßreaktor wieder abgeführt werden.

Oftmals ist es erwünscht, daß die erzeugten $SiO_2$-Schichten mit einem weiteren Element dotiert werden. Eine solche dotierte Schicht kann beispielsweise mittels thermischer Dotierung hergestellt werden. Dabei diffundiert der Dotierstoff aus der Gasphase in die zu dotierende Oberfläche. Die thermische Dotierung kann beispielsweise in einem CVD-Reaktor erfolgen, wobei die Dotierung gleichzeitig mit der $SiO_2$-Schichtabscheidung erfolgt, d.h. Dotieratome werden in das $SiO_2$-Gefüge eingebaut.

Ein in der Praxis verwendeter Dotierstoff ist beispielsweise Arsen (As). Die Erzielung einer As-dotierten $SiO_2$-Schicht auf einem Substrat erfolgt beispielsweise mittels thermischer Dotierung in einem CVD-Prozeßreaktor unter Verwendung von TEOS (Tetraethylorthosilikat) und TEAS (Triethylarsenat). Dieses so erzielte Arsen-Glas ist meist eine sogenannte Hilfsschicht und dient als Dotierstoffquelle. In einem nachfolgenden Temperprozeß diffundiert Arsen aus dem Arsen-Glas in das Silizium und erzeugt dort ein n-dotiertes Gebiet.

Die Anwendung des sogenannten TEAS-Verfahrens erfolgt bisher auf als Horizontalöfen ausgebildeten Prozeßreaktoren. Derartige Horizontalöfen bestehen aus einem horizontal ausgerichteten Prozeßrohr, das mit einer Vielzahl von Wafern bestückt werden kann. Der Horizontalofen ist mit einem Gasleitungssystem verbunden, über das TEOS und TEAS in das Prozeßrohr gelangen können. Die Verwendung des TEAS-Verfahrens auf Horizontalöfen weist jedoch eine Reihe von Nachteilen auf. So ist zunächst die Aufnahmekapazität eines Horizontalofens beim TEAS-Verfahren auf etwa 100 Wafer beschränkt, wodurch das Verfahren relativ kostenintensiv ist. Weiterhin können bei der Verwendung des TEAS-Verfahrens auf Horizontalöfen zwischen den einzelnen Prozeßzyklen des Ofens Unterschiede in der Schichtdicke sowie im Arsengehalt der Asdotierten $SiO_2$-Schicht auftreten, wodurch die Ausschußrate erhöht wird. Weiterhin ist auch die Gefahr eines relativ hohen Partikelniveaus in der Siliziumschicht gegeben. Ein Grund für die genannten Nachteile besteht unter anderem in dem relativ aufwendig ausgebildeten Gasleitungssystem, über das TEOS und TEAS in den Horizontalofen eingeführt werden. Insbesondere ist es mit dem bekannten Gasleitungssystem nicht möglich, ein derart definiertes TEOS/TEAS-Verhältnis einzustellen, daß stabile As-dotierte Siliziumschichten abgeschieden werden können.

Es ist daher die Aufgabe der Erfindung, die. im Stand der Technik genannten Nachteile zu vermeiden. Insbesondere soll ein Gasleitungssystem geschaffen werden, daß konstruktiv einfach aufgebaut ist und mit dem TEAS und TEOS derart geregelt in den Prozeßreaktor gelangen kann, daß eine stabile Schichtdicke und Arsengehalt bei den Siliziumschichten erreicht werden kann, bei gleichzeitiger Minimierung des Partikelniveaus. Außerdem soll gemäß einem dritten Aspekt der Erfindung ein verbessertes TEAS-Verfahren bereitgestellt werden.

Erfindungsgemäß wird die Aufgabe gelöst durch ein Gasleitungssystem für einen Prozeßreaktor zur Behandlung von Halbleitersubstraten, mit einem ersten Verdampfer zum Verdampfen von TEAS (Triethylarsenat), der eingangsseitig mit einer Trägergasquelle verbunden ist und ausgangsseitig wenigstens eine erste beheizte Leitung zum Verbinden des ersten Verdampfers mit einem Prozeßreaktor aufweist, und mit einem zweiten Verdampfer zum Verdampfen von TEOS (Tetraethylorthosilikat), der eingangsseitig mit einer Gasquelle (26) verbunden ist und ausgangsseitig wenigstens eine zweite beheizte Leitung zum Verbinden des zweiten Verdampfers mit dem Prozeßreaktor aüfweist.

Der Prozeßreaktor ist dabei bevorzugt ein Horizontal- oder Vertikalofen, wobei die Halbleitersubstrate typischerweise Wafer sind, die beispielsweise aus einem Siliziumgrundsubstrat bestehend. Der erste Verdampfer dient zum Verdampfen von TEAS. Bevorzugt erfolgt dies in einem sogenannten Bubbier (Vorrichtung zur Erzeugung von Gasblasen in einer Flüssigkeit mittels eines Trägergases). Dabei ist der Bubbler eingangsseitig mit einer Trägergasquelle und ausgangsseitig über wenigstens eine erste beheizte Leitung mit dem Prozeßreaktor verbunden. Weiterhin ist erfindungsgemäß ein zweiter und sogenannter TEOS-Verdampfer vorgesehen, der eingangsseitig mit einer Gasquelle und ausgangsseitig über wenigstens eine zweite beheizte Leitung mit dem Prozeßreaktor verbunden ist.

Durch das erfindungsgemäße Gasleitungssystem kann das TEAS-Verfahren nunmehr fertigungsgerecht prozessiert werden, insbesondere im Hinblick auf die Eliminierung von Schichtdicken- und Partikelproblemen sowie Problemen mit schwankendem Arsengehalt. Die Trägergasquelle hat die Funktion, das im TEAS-Bubbler (erster Verdampfer) befindliche TEAS zum Prozeßreaktor zu transportieren. Weiterhin dient das Trägergas als Spül- und Belüftungsgas. Das Gas der mit dem TEOS-Verdampfer (zweiter Verdampfer) verbundenen Gasquelle dient -wie weiter unten noch beschrieben wird- zur Befüllung des TEOS-Verdampfers. Der TEOS-Verdampfer kann erfindungsgemäß eine Edelstahlquelle mit einem Volumen von ungefähr 1.2 Litern sein. Weiterhin kann der TEAS-Bubbler eine Edelstahlquelle mit einem Volumen von ungefähr 1.5 Litern sein, wobei sich in der Edelstahlquelle etwa 800 g TEAS befinden können.

Weitere vorteilhafte Ausgestaltungen des erfindungsgemäßen Gasleitungssystems ergeben sich aus den Unteransprüchen.

Bevorzugt ist der erste Verdampfer (31) (TEAS-Verdampfer) ein Blasenverdampfer, der flüssiges TEAS enthält. Der zweite Verdampfer (TEOS-Verdampfer) enthält dagegen flüssiges TEOS. Bei dem Blasenverdampfer, auch Bubbler genannt, wird durch das TEAS ein Trägergas geleitet, in dem sich das TEAS als Gas teilweise löst. Der Grad der Sättigung des Trägergases mit TEAS wird dabei zum einen von der TEAS-Temperatur, und zum anderen von der Natur des Trägergases bestimmt. Weiterhin' kann durch einen hohen Durchfluß des Trägergases durch TEAS eine höhere Verdampfungsrate erreicht werden.

Erfindungsgemäß kann zwischen dem TEOS-Verdampfer und der Trägergasquelle ein TEOS-Tank, d.h. ein mit TEOS befüllter Flüssigkeitstank, angeordnet sein. Bei dem Tank handelt es sich vorteilhaft um einen Edelstahltank mit einem Fassungsvermögen von ungefähr 14 Litern.

In weiterer Ausgestaltung kann die im TEAS-Bubbler befindliche TEAS-Quelle über einen ersten Temperaturregler auf eine Temperatur von 25 bis 90°c, vorzugsweise 30 bis 50°C gebracht werden. Dabei kann es zur genauen Einstellbarkeit der Temperatur von Vorteil sein, wenn der Temperaturregler zumindest zwischen 25 und 90°C eine Regelgenauigkeit von ± 0.5°C aufweist.

Weiterhin kann die im TEOS-Verdampfer befindliche TEOS-Quelle über einen zweiten Temperaturregler vorteilhaft auf eine Temperatur von 25 bis 90°C, vorzugsweise 25 bis 35°C gebracht werden. Wiederum ist es für eine genaue Einstellbarkeit der Temperaturwerte von Vorteil, wenn der Temperaturregler zumindest zwischen 25 und 90°C eine Genauigkeit von ± 0.5°C aufweist.

In bevorzugter Ausgestaltung werden die Temperaturen in der TEAS-Quelle und/oder der TEOS-Quelle konstant gehalten. Eine konstante Temperatur im TEAS-Bubbler ist beispielsweise wichtig für den Sättigungsgrad des Trägergases. Eine konstante Temperatur im TEOS-Verdampfer hingegen ist wichtig für einen konstanten Dampfdruck des TEOS.

Damit ist die richtige Wahl der entsprechenden Temperaturen ein Aspekt zur Schaffung eines definierten TEOS/TEAS-Verhältnisses im Prozeßreaktor, wodurch unter anderem die Schichtdicke und der Arsengehalt stabilisiert werden können.

Erfindungsgemäß können die beheizten Leitungen des Gasleitungssystems einen Durchmesser > 6mm aufweisen. Bevorzugt beträgt der Durchmesser etwa 12mm. Durch die entsprechende Durchmesserwahl der beheizten Leitungen und insbesondere durch deren Beheizung kann der TEAS/TEOS-Fluß weiter optimiert werden. Die beheizten Leitungen sind vorteilhaft gezogene oder elektropolierte Edelstahlrohre, die orbital Schutzgas geschweißt sein können.

In weiterer Ausgestaltung können die (ersten und zweiten) beheizten Leitungen über eine Rohrbegleitheizung, vorzugsweise eine Vierkanalheizung beheizt werden. Dies läßt sich beispielsweise mittels einfacher, um die beheizten Leitungen gewickelte Heizbänder erreichen.

Dabei ist es von Vorteil, wenn in unterschiedlichen Bereichen der beheizten Leitungen unterschiedliche Temperaturen eingestellt werden, wobei vom TEAS-Bubbler und/oder vom TEOS-Verdampfer zum Prozeßreaktor hin ein steigendes Temperaturprofil eingestellt werden kann. Erfindungsgemäß können dabei in den beheizten Leitungen von dem TEAS-Bubbler zum Prozeßreaktor und/oder vom TEOS-Verdampfer zum Prozeßreaktor vier Bereiche unterschiedlicher Temperatur vorgesehen sein.

Die Temperatur in den unterschiedlichen Bereichen der jeweiligen beheizten Leitungen wird so gewählt, daß sich von der TEAS/TEOS-Quelle zum Prozeßreaktor hin jeweils ein steigendes Temperaturprofil einstellt. Dadurch wird beispielsweise Kondensationsbildung verhindert. Wenn beispielsweise die Temperatur im TEOS-Verdampfer auf einen Startwert von 25 bis 35°C festgelegt wird, kann in der ersten Zone der beheizten Leitung, die direkt von dem TEOS-Verdampfer abgeht, ein Temperaturwert von + 2°C im Vergleich zum Startwert eingestellt werden. In den weiteren Zonen bis hin zum Prozeßreaktor, beispielsweise in drei weiteren Zonen kann der Temperaturwert dann nochmals um jeweils 2°C erhöht werden. Eine identische Steigerung der Temperaturwerte kann beispielsweise auch in den unterschiedlichen Bereichen (Zonen) der beheizten Leitung eingestellt werden, über die der TEAS-Bubbler mit dem Prozeßreaktor verbunden ist. Hier ist nur zu beachten, daß der Temperaturstartwert in einem höheren Bereich von beispielsweise 30 bis 50°C liegen kann.

In bevorzugter Ausgestaltung kann in der wenigstens einen beheizten Leitung vom TEAS-Bubbler zum Prozeßreaktor wenigstens ein Ventil vorgesehen sein. Erfindungsgemäß kann darüber hinaus auch in der wenigstens einen beheizbaren Leitung vom TEOS-Verdampfer zum Prozeßreaktor wenigstens ein Ventil vorgesehen sein.

Dabei sind die Ventile in ihrer Große den beheizten Leitungen angepaßt. Als Ventiltypen können beispielsweise Handyentile oder druckluftbetätigte Ventile wie elektropneumatische Ventile verwendet werden. Jedoch ist die Verwendungsbandbreite für das erfindungsgemäße Gasleitungssystem nicht auf diese Ventiltypen beschränkt. Die Ventile dienen zur Regulierung beziehungsweise Absperrung des Mediumflusses in einzelnen Leitungen. Zusätzlich zu den genannten Ventilen können in dem erfindungsgemäßen Gasleitungssystem auch Rückschlagventile vorgesehen sein.

Erfindungsgemäß können der TEAS-Bubbler und die Trägergasquelle sowie der TEOS-Verdampfer und die Gasquelle jeweils über eine Leitung verbunden sein, wobei diese Leitungen erfindungsgemäß einen Durchmesser aufweisen, der geringer ist als der Durchmesser der beheizten Leitungen. Vorteilhaft können die Leitungen einen Durchmesser von $\leq$ 6mm, vorzugsweise von 6mm aufweisen. Dabei können die Leitungen unbeheizt sein. Wie die beheizten Leitungen können auch diese Leitungen aus gezogenen oder elektropolierten Rohren bestehen, die orbital Schutzgas geschweißt sein können.

In weiterer Ausgestaltung kann das Gas der Trägergasquelle Stickstoff ($N_2$) sein. Das Gas der Gasquelle kann erfindungsgemäß ein Inertgas, vorzugsweise Helium (He) sein.

Das erfindungsgemäße Gasleitungssystem ermöglicht eine optimale Zuführung von TEOS/TEAS in den Prozeßreaktor. Dadurch ist das auf den Wafern abgeschiedene As-dotierte Siliziumoxid relativ frei von Partikeln und weist eine gute Dichte auf. Weiterhin können durch die genaue und definierte Einstellbarkeit des TEAS/TEOS-Flusses die Schichtdicke und der Arsengehalt in den abgeschiedenen Schichten stabilisiert werden. Ausschlaggebend hierfür ist unter anderem ein genau dosiertes TEOS/TEAS-Verhältnis, däs insbesondere durch die erfindungsgemäße Beheizung einzelner Komponenten des Gasleitungsystems erreicht wird. Weiterhin ist das erfindungsgemäße Gasleitungssystem im Vergleich zu bekannten Gasleitungssystemen konstruktiv relativ einfach aufgebaut.

Bei dem erfindungsgemäßen Gasleitungssystem konnten die Gasleitungslängen und die Anzahl der Gasleitungen minimiert sowie die Gasleitungsführung optimiert werden. Ebenso konnte die Anzahl und der Einbauort der benötigten Ventile sowie die Konfiguration der Ventilsteuerungen optimiert werden. Schließlich wurde auch eine genaue Regulierbarkeit der unterschiedlichen Temperaturen erreicht. All diese konstruktiven Maßnahmen führen auch mit zu dem Effekt, daß dem Prozeßreaktor ein genau definiertes und fein eingestelltes Verhältnis von TEOS und TEAS zugeführt werden kann.

Gemäß einem weiteren Aspekt der Erfindung ist das Gasleitungssystem mit einem Prozeßreaktor verbunden, wobei der Prozeßreaktor ein Prozeßrohr aufweist, in dem ein rohrförmiger Liner sowie ein Träger für Halbleitersubstrate angeordnet ist, ein mit dem Prozeßrohr verbundener Flansch vorgesehen ist, ein Gaseinlaß und ein Gasauslaß am Prozeßreaktor vorgesehen sind, und der Gaseinlaß (16) über die erste und zweite beheizte Leitung (34, 35, 36, 37) jeweils mit dem ersten und zweiten Verdampfer (31, 32) verbunden ist.

Der Prozeßreaktor, insbesondere ein Vertikalofen zur Behandlung von Wafern, weist demnach ein Prozeßrohr auf, in dem ein rohrförmiger Liner (Mantel) sowie ein Boot (Träger bzw. Haltevorrichtung zur Aufnahme von Halbleitersubstraten, insbesondere von Wafern) vorgesehen sind. Ein mit dem Prozeßrohr verbundener Flansch dient zum Abdichten des Prozeßrohrs. Mittels des Gaseinlasses ist der Prozeßreaktor mit den ersten und zweiten beheizten Leitungen sowie mit den entsprechenden Verdampfern verbunden.

Die Verwendung eines Vertikalofens für das TEAS-Verfahren hat allgemein den Vorteil, daß eine bessere thermische Abschirmung erreicht werden kann und das durch die räumliche Trennung der Wafer mit dem über den Gasauslaß aus dem Ofen abströmenden Gas durch den rohrförmigen Liner (Mantel) eine negative Beeinflussung der Wafer verhindert wird. Insbesondere kann durch die erfindungsgemäße Anordnung eine stabilere Schichtdicke und ein stabilerer Arsengehalt auf den Wafern realisiert werden. Der Flansch ist vorteilhaft lösbar mit den anderen Komponenten des Vertikalofens verbunden. Dies empfiehlt sich deshalb, da bei der Abscheidung aus der Gasphase nicht nur die zu behandelnden Substrate, sondern auch alle anderen im Prozeßrohr befindlichen Elemente sowie die Innenwandungen des Prozeßrohrs selbst beschichtet werden. Diese Bauteile müssen deshalb von Zeit zu Zeit ausgewechselt werden.

In vorteilhafter Ausgestaltung sind der Gaseinlaß und/oder der Gasauslaß im Flansch angeordnet.

Erfindungsgemäß kann der Gaseinlaß eine Gaseinlaßöffnung für das TEOS-Gasversorgungssystem und eine Gaseinlaßöffnung für das TEAS-Gasversorgungssystem aufweisen.

In vorteilhafter Ausgestaltung ist am Flansch eine Heiz-/Kühlvorrichtung angeordnet. Da der Flansch einen großen metallischen Kühlkörper darstellt, kann durch dessen Beheizung eine Kondensation der Prozeßgase verhindert werden.

Bevorzugt weist das Medium der Heiz-/Kühlvorrichtung eine Temperatur von > 90°C auf.

Die Heiz-/Kühlvorrichtung zur Flanschthermostatisierung wird vorteilhaft mit Glykol als Medium betrieben und an die vorhandene Kühlschlange im Flansch anstelle der Kühlwasserversorgung angeschlossen. Ziel der Flanschkühlung/ -erwärmung ist es, zur Vermeidung der obigen Nachteile eine höhere Flanschtemperatur als bei bekannten Verfahren bisher üblich einzustellen. Da dies aber eine stärkere Temperaturbelastung der Dichtungen zur Folge hat, muß ein Dichtungsmaterial verwendet werden, das beispielsweise bis zu 250°C thermisch belastet werden kann. Ein solches. Dichtungsmaterial kann beispielsweise Teflon sein. Für den Fall, daß ein Ofentyp verwendet wird, bei dem keine Flanschkühlung vorhanden ist, an der eine Heiz-/ Kühlvorrichtung angeschlossen werden kann, kann der erwünschte Effekt auch durch eine beheizte Flanschummantelung erzielt werden. Die Heiz-/Kühlvorrichtung sollte so nah wie möglich am Flansch plaziert werden, um Wärmeverluste in den Leitungen zu vermeinden.

Erfindungsgemäß kann die Temperatur im Vertikalofen 400 bis 1250°C, vorzugsweise 600 bis 700°C betragen.

In weiterer Ausgestaltung kann der Gasdruck innerhalb des Vertikalofens 20 bis 100 Pa, vorzugsweise 66.6 ± 13.3 Pa (500 ± 100 mTorr) betragen. Dadurch haben die Abscheidungen eine gute Kantenbedeckung.

Durch den niedrigen Druck im Ofen kann der Konzentrationsgradient der Reaktionsgase innerhalb des Ofens so gering gehalten werden, daß an jeder Stelle auf den Substratoberflächen nahezu die gleiche Konzentration an Reaktionsgasen herrscht, wie sie der eingestellten Gasmischung entspricht. Dadurch können durch den herrschenden Druck innerhalb des Ofens die Schichtdicke und der Arsengehalt auf den einzelnen Wafern weiter stabilisiert werden.

Erfindungsgemäß können in dem Boot (Haltevorrichtung) mehr als 100 Wafer, vorzugsweise 150 produktive Wafer angeordnet sein. Damit können wesentlich mehr Wafer gleichzeitig bearbeitet werden als beim Horizontalofen wodurch die Herstellungskosten für die einzelnen Wafer weiter gesenkt werden können.

Durch den erfindungsgemäßen Vertikalofen wird erreicht, daß TEAS/TEOS in einem genau dosierten und definierten Verhältnis in den Ofen gelangen können. Gleichzeitig werden nachteilige Einflüsse durch die Beheizung des Flansches verhindert. Unter anderem dadurch wird die Verwendbarkeit des TEAS-Verfahrens auf einem Vertikalofen entscheidend verbessert.

Gemäß einem weiteren Aspekt der vorliegenden Erfindung wird ein Verfahren zur Abscheidung einer As-dotierten $SiO_2$-Schicht auf Halbleitersubstraten mit nachfolgenden Schritten:

- Bestücken eines Prozeßreaktors, der ein Prozeßrohr und einen Flansch aufweist, mit einer Vielzahl von zu behandelnden Halbleitersubstraten, wobei die Halbleitersubstrate in das Prozeßrohr eingebracht werden;
- Heizen des Prozeßreaktors auf eine Temperatur von 450 bis 1250°C, vorzugsweise 600 bis 700°C;
- Heizen des Flansches über eine am Flansch angeordnete Heiz-/Kühlvorrichtung, wobei die Heiz-/Kühlvorrichtung ein Medium enthält, das eine Temperatur größer 90°C aufweist;
- Einleiten von TEOS (Tetraethylorthosilikat) und TEAS (Triethylarsenat) in den Prozeßreaktor zum Abscheiden der As-dotierten $SiO_2$-Schicht, wobei TEAS über wenigstens eine erste beheizte Leitung aus einem ersten Verdampfer, der flüssiges TEAS enthält, und TEOS über wenigstens eine zweite beheizte Leitung aus einem zweitem Verdampfer, der flüssiges TEAS enthält, eingeleitet wird;
- Abscheiden der As-dotierten $SiO_2$-Schicht auf den Halbleitersubstraten.

Durch das effindungsgemäße Verfahren werden die im Hinblick auf die anderen Erfindungsaspekte vorstehend beschriebenen Vorteile, Effekte und Wirkungen bei der Abscheidung von Schichten auf den Waferoberflächen erreicht.

Insbesondere wird TEAS von dem geheizten TEAS-Bubbler über ein Trägergas -beispielsweise Stickstoff- in den Prozeßreaktor eingespeist, wo es bei einer erhöhten Temperatur -beispielsweise bei ungefähr 700°C- zusammen mit dem TEOS zu dem As-dotierten Siliziumoxid reagiert. Die Reaktion kann beispielsweise nach folgender Formel ablaufen:

$$OAs(OC_2H_5)_{3 \text{ an N2}} + Si(OC_2H_5)_{4 \text{ gasf.}} \rightarrow (As_2O_3 + SiO_2) + C_2H_4$$

Dabei lagert sich das Arsenatom im $SiO_2$-Kristall ein.

Bevorzugt kann im Prozeßreaktor ein Druck von 20 bis 100 Pa, vorzugsweise 66.6 ± 13.3 Pa (500 ± 100 mTorr) eingestellt werden. Die Vorteile des speziell eingestellten Drucks ergeben sich aus den vorstehenden Ausführungen zu den anderen Erfindungsaspekten.

In vorteilhafter Ausgestaltung kann das Verfahren über die Parameter Abscheidezeit, Temperatur, Druck und Verhältnis TEAS/TEOS geregelt werden.

Der TEOS-Fluß kann vorteilhaft über die TEOS-Verdampfungstemperatur eingestellt werden. Weiterhin kann der TEAS-Fluß erfindungsgemäß über die TEAS-Bubblertemperatur und den Fluß des Trägergases eingestellt werden. Dabei kann der Fluß des Trägergases vorteilhaft 50 bis 200 Standard-Kubikzentimeter pro Minute (sccm) betragen.

In weiterer Ausgestaltung wird eine As-dotierte $SiO_2$-Schicht mit einer Dicke von ungefähr 150 nm abgeschieden.

Erfindungsgemäß kann die As-dotierte $SiO_2$-Schicht einen Arsengehalt von 5.5% ± 2.5% aufweisen.

Die vorliegende Erfindung wird nun anhand von Ausführungsbeispielen unter Bezugnahme auf die beiliegende Zeichnung näher beschrieben. Es zeigt:

Fig.1 eine schematische Darstellung des Gasflußplans eines erfindungsgemäßen Gasleitungssystems;

Fig.2 eine schematische Querschnittsansicht eines als Vertikalofen ausgebildeten Prozeßreaktors;

Fig.3 eine vergrößerte perspektivische Ansicht eines Flansches des erfindungsgemäßen Vertikalofens;

Fig.4 ein Diagramm, in dem der Arsengehalt über der Waferposition im Prozeßreaktor aufgetragen ist; und

Fig.5 ein Diagramm, in dem der Arsengehalt über der Anzahl von Prozeßzyklen des Prozeßreaktors aufgetragen ist.

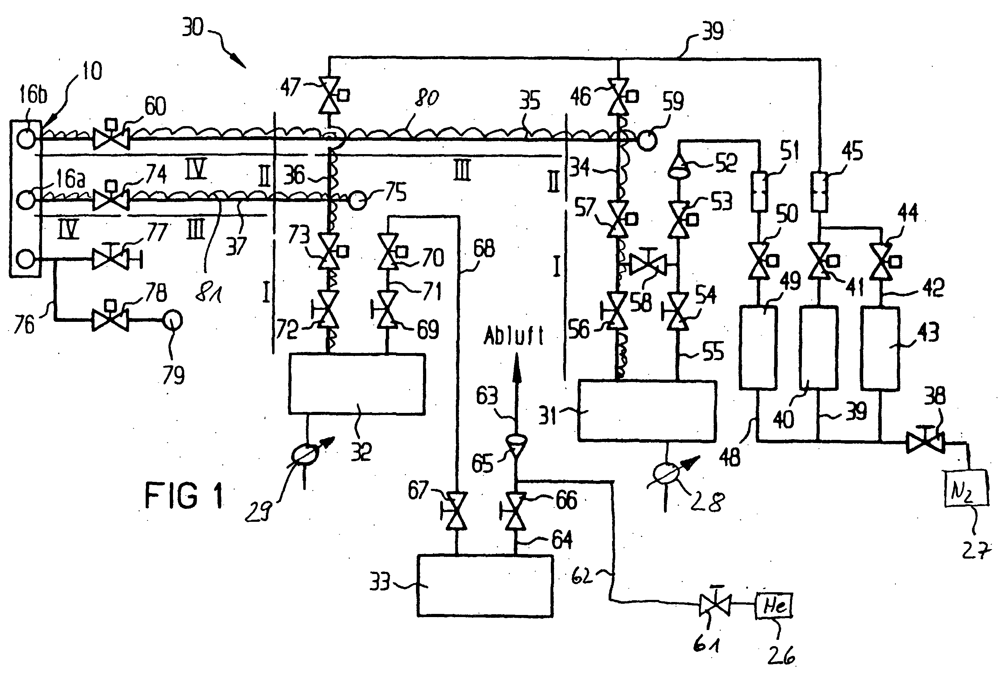

Fig.1 stellt den Gaslaufplan eines erfindungsgemäßen Gasleitungssystems 30 dar. Das Gasleitungssystem 30 ist über Gaseinlaßöffnungen 16a und 16b mit einem Prozeßreaktor, im vorliegenden Ausführungsbeispiel einem Vertikalofen 10 zur Behandlung von Wafern verbunden.

Wie aus Fig.1 ersichtlich ist, weist das Gasleitungssystem Leitungen unterschiedlicher Dicke auf. Die fett dargestellten Leitungen haben einen Durchmesser von 12mm und bestehen aus gezogenem oder elektropoliertem Edelstahl. Diese Leitungen sind beheizt. Die in Fig.1 durch dünne Striche dargestellten Leitungen haben einen Durchmesser von 6mm, sind ebenfalls aus gezogenem oder elektropoliertem Edelstahl hergestellt und im vorliegenden Ausführungsbeispiel unbeheizt.

Als Ventile werden entweder handbetätigte Ventile (zu erkennen an dem T-förmigen Symbol) oder elektropneumatische Ventile (zu erkennen an dem quadratischen Symbol) verwendet. Die Ventile sind in ihrer Größe an die jeweiligen Leitungsdurchmesser angepaßt.

Der Aufbau des Gasleitungssystems 30 ergibt sich wie folgt:

Ein TEOS-Verdampfer 32 ist mit einer Helium-Gasquelle (nicht dargestellt) verbunden. Anstelle des Heliums kann beispielsweise auch Stickstoff eingesetzt werden. Zwischen dem TEOS-Verdampfer 32 und der Helium-Gasquelle ist ein TEOS-Tank 33 vorgesehen. Das Helium wird über Leitungen 62 und 64 in den TEOS-Tank 33 geführt. Zur Steuerung des Gasflusses sind in den Leitungen 62 und 64 Ventile 61 und 66 vorgesehen. Im Verzweigungspunkt der Leitungen 62 und 64 ist weiterhin eine Leitung 63 mit einem Rückschlagventil 65 vorgesehen. Die Leitung 63 führt zu einem Abluft-Ausgang des Gasleitungssystems 30. Die Leitung 64 führt direkt in den TEOS-Tank 33 hinein. Vom Ausgang des TEOS-Tanks 33 führt eine Leitung 68 mit einem Ventil 67 zu dem TEOS-Verdampfer 32. Vor dem Eintritt in den TEOS-Verdampfer 32 mündet die Leitung 68 in eine beheizte Leitung 71 mit Ventilen 70 und 69. Ausgangsseitig führt vom TEOS-Verdampfer 32 eine beheizte Leitung 36- mit Ventilen 72 und 73 ab. Die Leitung 36 mündet einerseits in ein Ventil 47 und verzweigt sich andererseits in eine weitere beheizte Leitung 37 mit einem Ventil 74, über die der TEOS-Verdampfer 32 mit der Gaseinlaßöffnung 16a des Vertikalofens 10 verbunden ist. Zur Drucküberprüfung ist an der Leitung 37 ein Druckaufnehmer 75 vorgesehen.

Weiterhin weist das Gasleitungssystem 30 einen TEAS-Bubbler 31 auf, der mit einer Trägergasquelle (nicht dargestellt) verbunden ist. Im vorliegenden Ausführungsbeispiel wird als Trägergas Stickstoff verwendet. Der Stickstoff wird über ein Ventil 38 in das System eingespeist und strömt über eine Leitung 48 zum TEAS-Bubbler 31. In der Leitung 48 sind ein Massenflußregler (Mass Flow Controller) 49, Ventile 50, 53, 54, ein Gasfilter 51 sowie ein Rückschlagventil 52 angeordnet. Die Leitung 48 mündet im Ventil 54. Von diesem Ventil 54 abgehend ist ein beheiztes Leitungsstück 55 vorgesehen, das direkt in den TEAS-Bubbler 31 einmündet.

Ausgangsseitig geht vom TEAS-Bubbler 31 eine beheizte Leitung 34 ab, die einerseits in einem Ventil 46 endet und sich andererseits in eine beheizte Leitung 35 verzweigt, die über ein Ventil 60 mit der Gaseinlaßöffnung 16b des Vertikalofens verbunden ist.

Zwischen den Leitungen 48 und 43 ist weiterhin ein Bypass-Ventil 58 vorgesehen. In einigen Fällen, die nachfolgend noch genauer beschrieben werden, ist es wünschenswert, wenn das Trägergas Stickstoff etwa zum Spülen der Leitungen nicht durch den TEAS-Bubbler 31 hindurchgeleitet wird. Für diese Zwecke sind nach dem Eingangsventil 38 weitere Leitungen 39 und 42 vorgesehen, die jeweils einen Massenflußregler 40, 43 und ein Ventil 41, 44 aufweisen. Vor einem Gasfilter 45 werden die beiden Leitungen 39 und 42 zusammengeführt und als eine einzige Leitung 39 weitergeführt. Die Leitung 39 mündet über eine Verzweigung in das Ventil 46 und ist somit mit der vom TEAS-Bubbler 31 abgehenden beheizten Leitung 34 verbunden. In ihrem Endbereich mündet die Leitung 39 in das Ventil 47, so daß sie auch mit der vom TEOS-Verdamtfer 32 abgehenden beheizten Leitung 36 verbunden ist.

Für die Überwachung des Prozeßdrucks ist an dem Vertikalofen schließlich noch ein Druckaufnehmer 79 vorgesehen, der über eine beheizte Leitung 76 sowie Ventile 77, 78 mit dem Vertikalofen 10 verbunden ist.

Nachfolgend wird nun die Funktionsweise des Gasleitungssystems 30 beschrieben.

Während des Vor- und Hauptprozesses sollen TEAS und TEOS in einem definierten Verhältnis und Zustand in den Vertikalofen 10 eingespeist werden. Dazu wird das Helium-Gas über die Leitungen 62 und 64 zunächst in den ungeheizten TEOS-Tank 33 eingespeist. Das Helium hat den Zweck, den TEOS-Verdampfer 32 aus dem TEOS-Tank 33 zu befüllen. Aus dem TEOS-Tank 33 wird über die Leitungen 68 und 71 das TEOS in den TEOS-Verdampfer 32 eingespeist. Der TEOS-Verdampfer weist eine Temperatur von 25 bis 35°C auf. Dabei ist es wichtig, daß im TEOS-Verdampfer eine konstante Temperatur vorliegt, da diese für einen konstanten Dampfdruck des TEOS notwendig ist. Aus diesem Grund wird das vom TEOS-Tank 33 kommende TEOS bereits über die beheizte Leitung 71 vor dem Eintritt in den TEOS-Verdampfer 32 vorgewärmt. Das verdampfte TEOS gelangt über die beheizten Leitungen 36 und 37 zur Gaseinlaßöffnung 16a des Vertikalofens 10. In diesem Verfahrensstadium ist das Ventil 47 geschlossen.

Um genau definierte Einspeisungsverhältnisse des TEOS in den Vertikalofen zu ermöglichen, weisen die beheizten Leitungen 36, 37 Bereiche unterschiedlicher Temperatur auf. Diese Temperatureinstellungen erfolgen über eine Vierkanal-Rohrbegleitheizung (nicht dargestellt). Im vorliegenden Ausführungsbeispiel sind insgesamt vier Bereiche I, II, III und IV unterschiedlicher Temperatur vorgesehen. Dabei ist zu beachten, daß das Temperaturprofil in den beheizten Leitungen 36, 37 vom TEOS-Verdampfer 32 zum Vertikalofen 10 hin ansteigt. Der erste Bereich I, der sich direkt an den Ausgang des TEOS-Verdampfers 32 anschließt, hat eine Temperatur, die im Vergleich zur Temperatur in dem TEOS-Verdampfer 32 um 2°C erhöht ist. In den darauffolgenden Bereichen II, III und IV wird die Temperatur dann noch einmal um jeweils 2°C erhöht, so daß das TEOS mit einer Temperatur in den Vertikalofen 10 gelangt, die um 8°C höher liegt als die Temperatur im TEOS-Verdampfer 32.

Zur Einspeisung von TEAS in den Vertikalofen 10 wird zunächst das Trägergas Stickstoff in den TEAS-Bubbler 31 eingespeist. Dazu sind die Ventile 41 und 44 geschlossen, so daß der Stickstoff durch die Leitung 48 strömt. Dabei passiert das Gas den Massenflußregler 49, durch den der Gasfluß im Bereich von 0 bis 200 Standardkubikzentimeter pro Minute (sccm) einstellbar ist. Da das Bypass-Ventil 58 geschlossen ist, gelangt der Stickstoff über den beheizten Leitungsabschnitt 55 schließlich in den TEAS-Bubbler 31. In dem Bubbler liegt eine Temperatur von 30 bis 50°C vor, die wiederum konstant gehalten werden muß, da eine konstante Temperatur im TEAS-Bubbler 31 wichtig für den Sättigungsgrad des Trägergases ist. Das TEAS mit dem Trägergas wird über die beheizten Leitungen 34 und 35 in den Vertikalofen 10 eingespeist. Dabei ist das Ventil 46 geschlossen. Ähnlich wie beim TEOS-Verdampfer 32 weisen auch die Leitungen 34, 35 Bereiche unterschiedlicher Temperatur auf, die über eine Vierkanal-Rohrbegleitheizung eingestellt werden. Wiederum sind vier Bereiche I, II, III und IV vorgesehen, in denen die Temperatur des vom TEAS-Bubbler 31 ausgehenden TEAS bis hin zum Vertikalofen um jeweils 2°C erhöht wird. Das TEAS wird schließlich über die Gaseinlaßöffnung 16b in den Vertikalofen eingespeist.

Die Druckkontrolle der beheizten Leitungen 34, 35 und 36, 37 erfolgt über die Druckaufnehmer 59 und 75.

Vor oder nach dem Hauptprozeß kann es erwünscht sein, daß der Vertikalofen 10 im Standby-Betrieb gespült werden oder aber der evakuierte Vertikalofen belüftet werden soll. Beides erfolgt mit Hilfe des Trägergases Stickstoff.

Zum Spülen des Vertikalofens 10 wird das Ventil 50 geschlossen und das Ventil 41 geöffnet, so daß der Stickstoff über den Massenflußregler 40 in die Leitung 39 einströmen kann. Dabei ist der Massenflußregler 40 im Bereich von 0 bis 2 Standard Liter pro Minute stufenlos einstellbar.

Im Bereich der Verzweigung vor dem Ventil 46, das geöffnet ist, teilt sich des Stickstoff-Gasfluß zu gleichen Teilen auf, so daß bei Öffnung des Ventils 47 die beheizten Leitungen 35, teilweise 34, 37 und teilweise 36 vom Stickstoff gespült werden. Natürlich können durch entsprechende Ventileinstellungen die TEOS- und TEAS-Leitungen auch nacheinander gespült werden. Der in der Leitung 39 vorgesehene Gasfilter hat die Funktion, insbesondere die beheizten Leitungen und die Wafer vor Verunreinigungen zu schützen.

Beim Belüften des evakuierten Vertikalofens 10 auf atmosphärischen Druck wird zusätzlich zum Spülen noch das Ventil 44 und der Massenflußregler 43 angesteuert. Der Massenflußregler ist in einem Bereich von 0 bis 10 Standard Liter pro Minute stufenlos einstellbar. Durch diese zusätzliche Ansteuerung wird der für das Belüften notwendige höhere Gasfluß erreicht.

Vor dem Wechsel der TEAS-Quelle ist üblicherweise nötig, daß die beheizten TEAS-Leitungen 34 und 35 freigespült werden. Dies wird wie folgt erreicht: Da zum Wechsel der TEAS-Quelle der TEAS-Bubbler 31 oberhalb der Ventile 54 und 56 abgeschraubt werden muß, müssen diese Ventile zunächst geschlossen werden. Gleichzeitig muß das Bypass-Ventil 58 geöffnet werden. Bei geschlossenen Ventilen 41, 44 und geöffnetem Ventil 50 strömt Stickstoff durch die Leitung 48 und über das Bypassventil 58 und das geöffnete Ventil 57 in die beheizten Leitungen 34 und 35, wodurch diese gespült werden.

Schließlich ist es erforderlich, daß der TEOS-Verdampfer 32 nach jeder Prozeßfahrt nachbefüllt werden muß, um einen konstanten Füllstand zu gewährleisten. Um den TEOS-Verdampfer 32 nachzufüllen ist es wichtig, daß das Helium mit einem Befülldruck von kleiner 68,95 kPa (10 PSI) verwendet wird. Das Helium drückt das flüssige TEOS aus dem TEOS-Tank 33 in die Leitung 68, wo es zunächst am. geschlossenen Ventil 70 ansteht. Mit dem Öffnen des Ventils 70 beginnt der Befüllvorgang. Abhängig von einer in einem Steuerprogramm eingestellten Zeit oder Abhängigkeit von einem Füllstandsensor wird die Befüllung durch Schließen des Ventils 70 automatisch gestoppt. Sollte es beispielsweise durch eine Fehlfunktion zu einem He-Druck von über 68,95 kPa (10 PSI) kommen, so wird der Überdruck über das Rückschlagventil 65 abgeleitet. Dadurch wird das Gasleitungssystem 30 vor zu hohem Gasdruck geschützt und ein unkontrolliertes Befüllen verhindert.

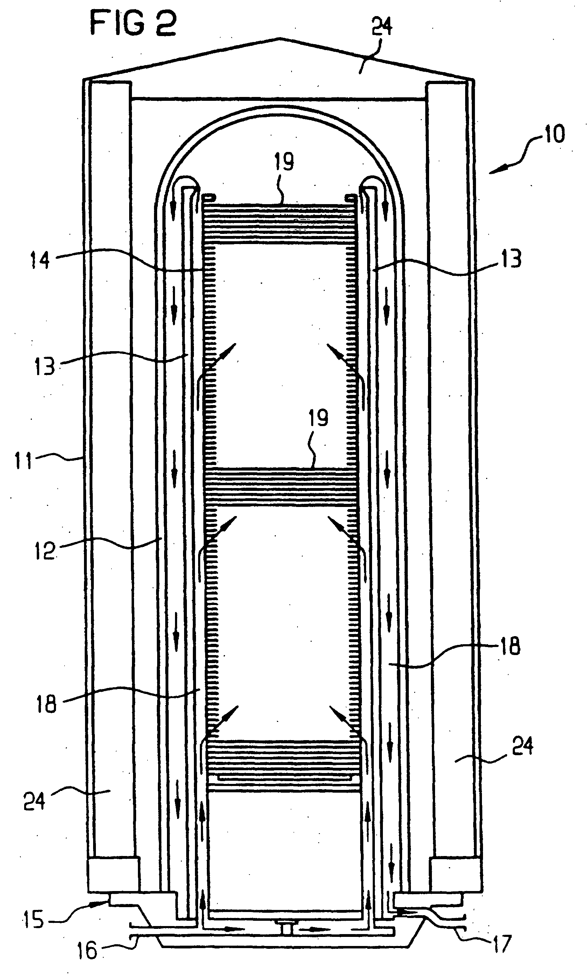

In Fig.2 ist in stark vereinfachter Weise ein Ausführungsbeispiel des erfindungsgemäßen Prozesreaktors in Form eines Vertikalofens 10 dargestellt. Der Vertikalofen 10 besteht aus einem Ofengehäuse 11, das innenseitig mit einer Heizkassette 24 versehen ist. Hier kann beispielsweise eine 5-Zonen-Heizkassette verwendet werden. Innerhalb der Heizkassette 24 ist ein Prozeßrohr 12 vorgesehen, das lösbar mit einem Flansch 15 verbunden ist. Innerhalb des Prozeßrohrs 12 ist weiterhin ein rohrförmiger oder zylindrischer Liner (Mantel) 13 vorgesehen, der zur Abschirmung eines Boots (Haltevorrichtung) 14 zur Aufnahme einer Vielzahl von Wafern 19 dient. Die Wandungen des Prozeßrohrs 12, des Liners (Mantels) 13 und des Boots (Haltevorrichtung) 14 bilden einen Strömungskanal 18. Sowohl das Boot (Haltevorrichtung) 14 als auch der Liner (Mantel) 13 sind lösbar mit dem Flansch 15 verbunden. Der Flansch 15 verfügt über einen Gaseinlaß 16 und einen Gasauslaß 17.

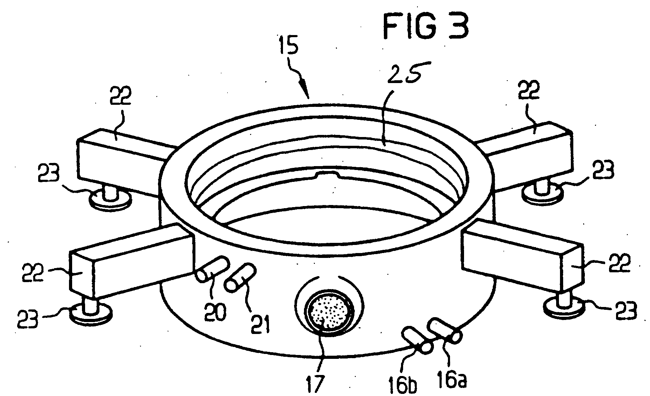

Wie weiterhin aus Fig.3 ersichtlich ist, weist der Flansch 15 als Gaseinlaß jeweils eine Gaseinlaßöffnung 16a und eine Gaseinlaßöffnung 16b auf, über die der Vertikalofen 10 mit dem vorstehend beschriebenen Gasleitungssystem 30 gemäß Fig.1 verbunden werden kann. Weiterhin weist der Flansch 15 Anschlüsse 20, 21 für eine Heiz-/Kühlvorrichtung (nicht. dargestellt) auf, über die der Flansch 15 beheizt werden kann. Zur sicheren und festen Abstützung des Flansches 15 und damit des Vertikalofens 10 auf dem Untergrund sind eine Reihe von Stützbeinen 22 und Stützfüßen 23 vorgesehen.

Der Betrieb des Vertikalofens 10 und die Durchführung des TEAS-Verfahrens werden nunmehr unter Bezugnahme auf die Fig.2 und 3 sowie 4 und 5 beschrieben.

Mit Hilfe des TEAS-Verfahrens sollen auf Wafern mittels Gasphasenabscheidung jeweils As-dotierte $SiO_2$-Schichten abgeschieden werden. Um eine stabile Schichtdicke von 150 nm auf den Wafern zu realisieren und um zu erreichen, daß jede der abgeschiedenen Schichten einen Arsengehalt von $5.5\% \pm 2.5\%$ aufweist, müssen eine Reihe von Parametern erfüllt sein. Zunächst muß in dem Vertikalofen 10 eine geeignete Temperatur und ein geeigneter Druck eingestellt werden. Weiterhin muß die Flanschtemperatur geeignet eingestellt werden. Schließlich muß dem Vertikalofen ein definiertes TEOS/TEAS-Verhältnis zugeführt werden.

Um eine geeignete Abscheidung von As-dotierten $SiO_2$-Schichten auf den Wafern 19 zu erreichen, wird zunächst das Boot (Haltevorrichtung) 14 mit einer Vielzahl von Wafern 19 bestückt. Im vorliegenden Ausführungsbeispiel wird das Boot (Haltevorrichtung) 14 des Vertikalofens 10 mit insgesamt 166 Wafern 19 bestückt, wovon 150 Wafer produktive Wafer sind.

Anschließend wird der Ofeninnenraum innerhalb des Prozeßrohrs auf eine Temperatur von 600 bis 700°C erhitzt. Gleichzeitig wird der Druck im Prozeßrohr 12 auf einen Wert von $66.6 \pm 13.3$ Pa eingestellt. Durch diesen niedrigen Druck wird ein solch geringer Konzentrationsgradient erreicht, daß während des Prozesses an jeder Stelle auf den Waferoberflächen nahezu die gleiche Konzentration an Reaktionsgasen herrscht. Anschließend wird der Flansch 15 über das Heiz-/Kühlsystem beheizt, wobei das im Heiz-/Kühlsystem befindliche Medium auf eine Temperatür größer 90°C gebracht wird. Dadurch wird eine undefinierte Abscheidung der Prozeßgase am Flansch verhindert. Schließlich'wird über die Gaseinlaßöffnungen 16a und 16b TEAS und TEOS aus dem Gasleitungssystem 30 in der vorstehend beschriebenen Art und Weise zugeführt. Das einströmende Gas strömt im Strömungskanal 18, der durch den Liner (Mantel) 13 und das Boot (Haltevorrichtung) 14 gebildet wird, nach oben, wobei das Gäs auch die Wafer 19 umspült. Durch die entsprechenden Gasreaktionen kommt es zu den gewünschten Abscheidungen auf den Wafern 19. Am freien Ende des Strömungskanals 18 wird der Gasfluß umgelenkt und über denjenigen Teil des Strömungskanals 18, der durch den Liner (Mantel) 13 und das Prozeßrohr 12 gebildet wird, wieder in Richtung des Flanschs 15 geleitet. Im Flansch 15 ist ein Gasauslaß 17 vorgesehen, durch den das Reaktionsgas nach außen abgeführt wird. In Fig.2 ist des Strömungsverlauf des Gases durch Pfeile dargestellt.

Durch dieses Verfahren werden abgeschiedene Schichten auf den Wafern erzeugt die den oben genannten Voraussetzungen, insbesondere im Hinblick auf Stabilität in der Schichtdicke und dem Arsengehalt voll genügen.

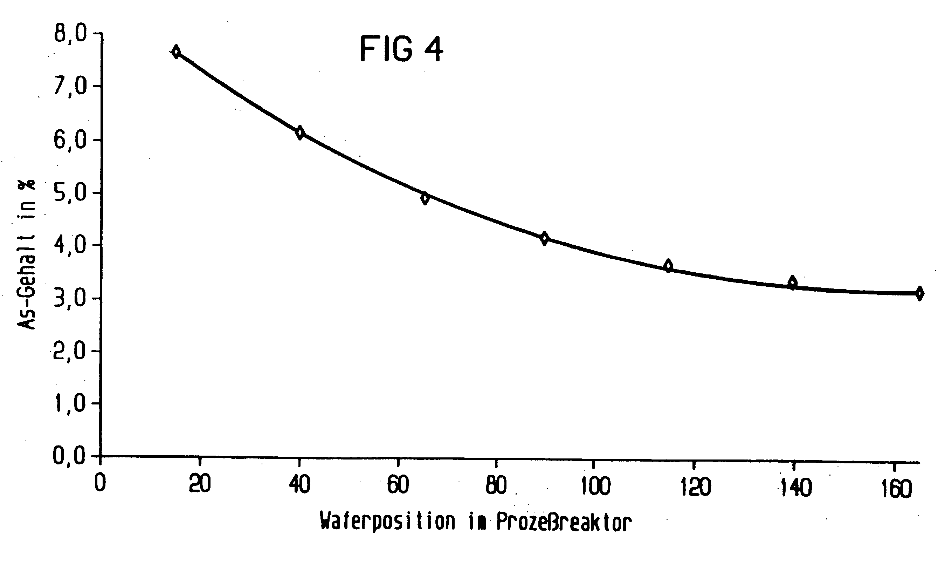

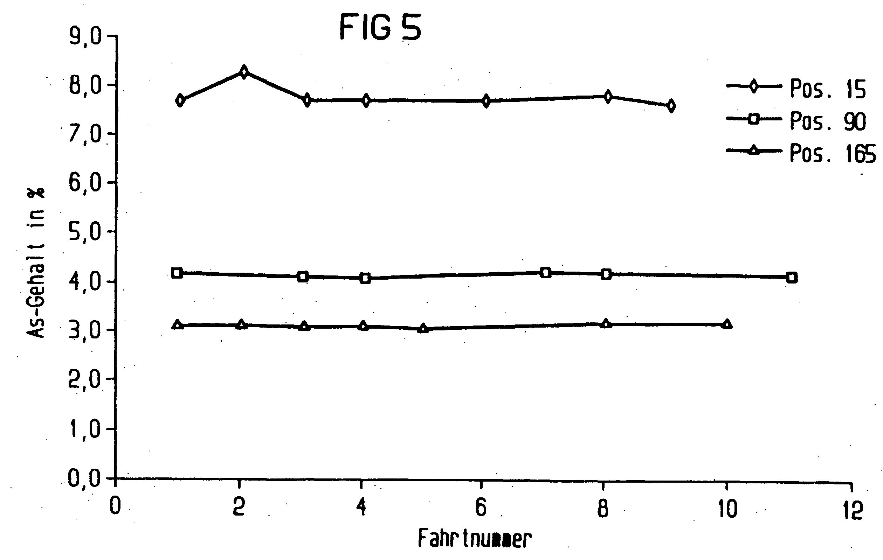

Beispiele für mit dem TEAS-Verfahren auf dem Vertikalofen 10 erzielte Ergebnisse sind in den Fig.4 und 5 dargestellt.

Fig.4 stellt ein Diagramm dar, bei dem der Arsengehalt über der entsprechenden Waferposition im Prozeßreaktor -hier dem Vertikalofen 10- dargestellt ist. Die Wafer-Position 0 liegt dabei in der Nähe des Gaseinlasses 16 (Fig.2), während die Position 166 die am weitesten vom Gaseinlaß 16 entfernt liegende Wafer-Position ist. Wie sich aus dem Kurvenverlauf von Fig.4 ergibt, ist in allen Bereichen des Verikalofens über seine gesamte Länge die Voraussetzung erfüllt, das der Arsengehalt in den abgeschiedenen Schichten in einem Bereich von $5.5\% \pm 2.5\%$ variieren soll.

In Fig.5 ist ein Diagramm dargestellt, bei dem der Arsengehalt der abgeschiedenen Schichten über der Fahrtnummer aufgetragen ist. Dabei wird als Fahrt der folgende Arbeitsablauf bezeichnet: Bestücken des Vertikalofens mit 166 Wafern, Durchführung des TEAS-Verfahrens, prozessierte Wafer aus dem Vertikalofen entladen, Prozeßergebnisse messen. In der Fig.5 sind insgesamt drei Kurven dargestellt, wobei jede Kurve für eine bestimmte Waferposition im Vertikalofen ermittelt wurde. Die mit Rauten versehene Kurve wurde an der Waferposition 15 und damit in der Nähe des Gaseinlasses ermittelt. Die Kurve mit den Quadraten wurde bei Waferposition 90 und damit in der Mitte des Vertikalofens aufgenommen. Die Kurve mit den Dreiecken schließlich wurde für die Waferposition 165 ermittelt. Diese Position entspricht der vom Gaseinlaß am entferntesten liegenden Position im Vertikalofen.

Wie sich aus den Kurven gemäß Fig.5 ergibt, ist an allen Positionen im Vertikalofen der Arsengehalt bis zu zehn Fahrten im wesentlichen konstant, so daß das erfindungsgemäße Verfahren geeignet ist, stabile Arsengehalte auch über einen längeren Zeitraum zu erzeugen. Beachtenswert dabei ist die Tatsache, daß die Arsengehalte auch während nachfolgender Prozeßfahrten kaum variieren. Dies ist eine besondere Verbesserung im Hinblick auf die im Stand der Technik bekannten Systeme. Weiterhin zeigt auch Fig.5 noch einmal deutlich, daß der Arsengehalt über den gesamten Längsbereich des Vertikalofens in dem erforderlichen Bereich für eine optimale Arsenabscheidung liegt.

**Patentansprüche**

1. Gasleitungssystem für einen Prozeßreaktor zur Behandlung von Halbleitersubstraten,

   - mit einem ersten Verdampfer (31) zum Verdampfen von TEAS (Triethylarsenat), der eingangsseitig mit einer Trägergasquelle (27) verbunden ist und ausgangsseitig wenigstens eine erste beheizte Leitung (34, 35) zum Verbinden des ersten Verdampfers (31) mit einem Prozeßreaktor (10) aufweist, und
   - mit einem zweiten Verdampfer (32) zum Verdampfen von TEOS (Tetraethylorthosilikat), der eingangsseitig mit einer Gasquelle (26) verbunden ist und ausgangsseitig wenigstens eine zweite beheizte Leitung (36, 37) zum Verbinden des zweiten Verdampfers mit dem Prozeßreaktor (10) aufweist.

2. Gasleitungssystem nach Anspruch 1, **dadurch gekennzeichnet, daß** zwischen dem zweiten Verdampfer (32) und der Gasquelle (26) ein mit TEOS befüllter Flüssigkeitstank (33) angeordnet ist.

3. Gasleitungssystem nach Anspruch 1 oder 2, **dadurch gekennzeichnet, daß** der erste Verdampfer (31) zumindest einen ersten Temperaturregler (28) zum Regeln der Temperatur in dem ersten Verdampfer (31) aufweist.

4. Gasleitungssystem nach einem der Ansprüche 1 bis 3, **dadurch gekennzeichnet, daß** der zweite Verdampfer (32) zumindest einen zweiten Temperaturregler (29) zum Regeln der Temperatur in dem zweiten Verdampfer (32) aufweist.

5. Gasleitungssystem nach einem der vorherigen Ansprüche, **dadurch gekennzeichnet, daß** der erste Temperaturregler (28) und der zweite Temperaturregler (29) im Bereich zwischen 25°C bis 90°C eine Regelgenauigkeit von ± 0.5°C aufweisen.

6. Gasleitungssystem nach einem der vorherigen Ansprüche, **dadurch gekennzeichnet, daß** die ersten und zweiten beheizten Leitungen (34, 35, 36, 37) einen Durchmesser von größer 6 mm, vorzugsweise einen Durchmesser von 12 mm aufweisen.

7. Gasleitungssystem nach einem der vorherigen Ansprüche, **dadurch gekennzeichnet, daß** die ersten und zweiten beheizten Leitungen (34, 35, 36, 37) über jeweils eine Rohrbegleitheizung (80, 81) beheizt sind.

8. Gasleitungssystem nach Anspruch 7, **dadurch gekennzeichnet, daß** mittels der Rohrbegleitheizungen (80, 81) jeweils eine konstante Temperatur der ersten und zweiten beheizten Leitungen (34, 35, 36, 37) einstellbar ist.

9. Gasleitungssystem nach Anspruch 7, **dadurch gekennzeichnet, daß** die Rohrbegleitheizungen (80, 81) jeweils in mehrere Bereiche unterteilt sind, deren jeweilige Temperatur individuell einstellbar ist, so daß die ersten und zweiten beheizten Leitungen (34, 35, 36, 37) entsprechend der Bereiche der Rohrbegleitheizung (80, 81) eine unterschiedliche Temperatur aufweisen.

10. Gasleitungssystem nach Anspruch 9, **dadurch gekennzeichnet, daß** ausgehend vom ersten und/oder zweiten Verdampfer (31, 32) zum Prozeßreaktor (10) hin die Temperatur des nächstfolgenden Bereichs höher als die Temperatur der vorherigen Bereichs ist.

11. Gasleitungssystem nach Anspruch 10, **dadurch gekennzeichnet, daß** die Rohrbegleitheizungen jeweils in vier Bereiche aufgeteilt sind, wobei aneinander grenzende Bereiche einen Temperaturunterschied von etwa 2°C aufweisen.

12. Gasleitungssystem nach einem der Ansprüche 1 bis 11, **dadurch gekennzeichnet, daß** der erste Verdampfer (31) und die Trägergasquelle (27) über wenigstens eine Leitung (48) miteinander verbunden sind, daß der zweite Verdampfer (32) und die Gasquelle (26) über wenigstens eine weitere Leitung (62, 68) miteinander verbunden sind, und daß die Leitung (48) und die weitere Leitung (48, 62, 68) einen Durchmesser aufweisen, der kleiner als der Durchmesser der ersten und zweiten beheizten Leitungen (34, 35, 36, 37) ist.

13. Gasleitungssystem nach Anspruch 12, **dadurch gekennzeichnet, daß** der Durchmesser der Leitung (48) und der weiteren Leitung (48, 62, 68) kleiner gleich 6 mm ist.

14. Gasleitung nach einem der vorhergehenden Ansprüche, **dadurch gekennzeichnet, daß** das Gas der Trägergasquelle (27) Stickstoff ($N_2$) ist.

15. Gasleitung nach einem der vorhergehenden Ansprüche, **dadurch gekennzeichnet, daß** das Gas der Gasquelle (26) ein Inertgas, vorzugsweise Helium ist.

16. Gasleitungssystem nach einem der vorherigen Ansprüche, **dadurch gekennzeichnet, daß** der erste Verdampfer (31) ein Blasenverdampfer (31) ist und flüssiges TEAS enthält und der zweite Verdampfer (32) flüssiges TEOS enthält.

17. Gasleitungssystem nach einem der vorherigen Ansprüche, **dadurch gekennzeichnet, daß**

- der Prozeßreaktor (10) ein Prozeßrohr (12) aufweist, in dem ein rohrförmiger Liner (13) sowie ein Träger (14) für Halbleitersubstrate (19) angeordnet ist,
- ein mit dem Prozeßrohr (12) verbundener Flansch (15) vorgesehen ist,
- ein Gaseinlaß (16) und ein Gasauslaß (17) am Prozeßreaktor vorgesehen sind, und.
- der Gaseinlaß (16) über die. erste und zweite beheizte Leitung (34, 35, 36, 37) jeweils mit dem ersten und zweiten Verdampfer (31, 32) verbunden ist.

18. Gasleitungssystem nach Anspruch 17, **dadurch gekennzeichnet, daß** der Gaseinlaß (16) und/oder der Gasauslaß (17) im Flansch (15) angeordnet ist.

19. Gasleitungssystem nach Anspruch 17 oder 18, **dadurch gekennzeichnet, daß** der Gaseinlaß (16) zumindest zwei Gaseinlaßöffnungen (16a, 16b) aufweist, wobei eine Gaseinlaßöffnung (16a) mit dem zweiten Verdampfer (32) und die andere Gaseinlaßöffnung (16b) mit dem ersten Verdampfer (31) verbunden ist.

20. Gasleitungssystem nach einem der Ansprüche 17 bis 19, **dadurch gekennzeichnet, daß** am Flansch (15) eine Heiz-/Kühlvorrichtung (25) angeordnet ist.

21. Gasleitungssystem nach einem der Ansprüche 17 bis 20, **dadurch gekennzeichnet, daß** der Träger (14) zur Aufnahme von mehr als 100 Halbleitersubstraten (19), vorzugsweise etwa 150 Halbleitersubstrate (19), ausgebildet ist.

22. Verfahren zur Abscheidung einer As-dotierten $SiO_2$-Schicht auf Halbleitersubstraten, **gekennzeichnet durch** folgende Schritte:

- Bestücken eines Prozeßreaktors (10), der ein Prozeßrohr (12) und einen Flansch (15) aufweist, mit einer Vielzahl von zu behandelnden Halbleitersubstraten (19), wobei die Halbleitersubstrate (19) in das Prozeßrohr eingebracht werden;
- Heizen des Prozeßreaktors (10) auf eine Temperatur von 450 bis 1250°C, vorzugsweise 600 bis 700°C;
- Heizen des Flansches über eine am Flansch angeordnete Heiz-/Kühlvorrichtung (25), wobei die Heiz-/Kühlvorrichtung (25) ein Medium enthält, das eine Temperatur größer 90°C aufweist;
- Einleiten von TEOS (Tetraethylorthosilikat) und TEAS (Triethylarsenat) in den Prozeßreaktor (10) zum Abscheiden der As-dotierten $SiO_2$-Schicht, wobei TEAS über wenigstens eine erste beheizte Leitung (34, 35) aus einem ersten Verdampfer (31), der flüssiges TEAS enthält, und TEOS über wenigstens eine zweite beheizte Leitung (36, 37) aus einem zweitem Verdampfer (32), der flüssiges TEAS enthält, eingeleitet wird;
- Abscheiden der As-dotierten $SiO_2$-Schicht auf den Halbleitersubstraten (19).

23. Verfahren nach Anspruch 22, **dadurch gekennzeichnet, daß** in dem Prozeßreaktor (10) ein Druck von 20 bis 100 Pa, vorzugsweise 66.6 ± 13.3 Pa eingestellt wird.

**24.** Verfahren nach Anspruch 22 oder 23, **dadurch gekennzeichnet, daß** das flüssige TEAS im ersten Verdampfer (31) auf eine konstante Temperatur zwischen 25°C und 90°C, vorzugsweise zwischen 30°C und 50°C, mit einer Genauigkeit von ± 0.5°C eingestellt wird.

**25.** Verfahren nach einem der Ansprüche 22 bis 24, **dadurch gekennzeichnet, daß** das flüssige TEOS im zweiten Verdampfer (32) auf eine konstante Temperatur zwischen 25°C und 90°C, vorzugsweise zwischen 25°C und 35°C, mit einer Genauigkeit von ± 0.5°C eingestellt wird.

**26.** Verfahren nach einem der Ansprüche 22 bis 25, **dadurch gekennzeichnet, daß** der TEOS-Fluß über die TEOS-Verdampfungstemperatur im zweiten Verdampfer (32) eingestellt wird.

**27.** Verfahren nach einem der Ansprüche 22 bis 26, **dadurch gekennzeichnet, daß** TEAS mittels Durchblasen eines inerten Gases, vorzugsweise Stickstoffgas ($N_2$), durch das flüssige TEAS im ersten Verdampfer (31) verdampft wird.

**28.** Verfahren nach einem der Ansprüche 23 bis 27, **dadurch gekennzeichnet, daß** der TEAS-Fluß über die Temperatur im ersten Verdampfer (31) und den Fluß des Trägergases eingestellt wird.

**29.** Verfahren nach Anspruch 28, **dadurch gekennzeichnet, daß** der Fluß des Trägergases 50 bis 200 Standard-Kubikzentimeter pro Minute (sccm) beträgt.

**30.** Verfahren nach einem der Ansprüche 22 bis 29, **dadurch gekennzeichnet, .daß** die Abscheidezeit, Temperatur und Druck im Prozeßreaktor, Verdampfungsrate von TEAS und TEOA sowie das Verhältnis TEAS/TEOS so aufeinander abgestimmt sind, daß eine As-dotierte $SiO_2$-Schicht mit einer Dicke von ungefähr 150 nm abgeschieden wird.

**31.** Verfahren nach einem der Ansprüche 22 bis 30, **dadurch gekennzeichnet, daß** die abgeschiedene As-dotierte $SiO_2$-Schicht einen Arsengehalt von 5.5% ± 2.5% aufweist.

**Claims**

**1.** Gas pipe system for a process reactor for treatment of semiconductor substrates,

- having a first evaporator (31) for vaporizing TEAS (triethylarsenate), which is connected on the input side to a carrier gas source (27) and, on the output side, has at least one first heated pipe (34, 35) for connecting the first evaporator (31) to a process reactor (10), and
- having a second evaporator (32) for vaporizing TEOS (tetraethylorthosilicate), which is connected on the input side to a gas source (26) and, on the output side, has at least one second heated pipe (36, 37) for connecting the second evaporator to the process reactor (10).

**2.** Gas pipe system according to Claim 1, **characterized in that** a liquid tank (33) filled with TEOS is arranged between the second evaporator (32) and the gas source (26).

**3.** Gas pipe system according to Claim 1 or 2, **characterized in that** the first evaporator (31) has at least one first temperature controller (28) for regulating the temperature in the first evaporator (31).

**4.** Gas pipe system according to one of Claims 1 to 3, **characterized in that** the second evaporator (32) has at least one second temperature controller (29) for regulating the temperature in the second evaporator (32).

**5.** Gas pipe system according to one of the preceding claims, **characterized in that** the first temperature controller (28) and the second temperature controller (29) have a regulation accuracy of ± 0.5°C in the range between 25°C and 90°C.

**6.** Gas pipe system according to one of the preceding claims, **characterized in that** the first and second heated pipes (34, 35, 36, 37) have a diameter of more than 6 mm, preferably a diameter of 12 mm.

**7.** Gas pipe system according to one of the preceding claims, **characterized in that** the first and second heated pipes (34, 35, 36, 37) are each heated via a pipeline heater (80, 81).

8. Gas pipe system according to Claim 7, **characterized in that** the pipeline heaters (80, 81) can each be used to set a constant temperature in the first and second heated pipes (34, 35, 36, 37).

9. Gas pipe system according to Claim 7, **characterized in that** the pipeline heaters (80, 81) are each subdivided into a number of areas, whose respective temperature can be adjusted individually, so that the first and second heated pipes (34, 35, 36, 37) have a different temperature corresponding to the areas of the pipeline heaters (80, 81).

10. Gas pipe system according to Claim 9, **characterized in that**, starting from the first and/or second evaporator (31, 32), the temperature of the next area towards the process reactor (10) is higher than the temperature in the preceding area.

11. Gas pipe system according to Claim 10, **characterized in that** the pipeline heaters are each subdivided into four areas, with mutually adjacent areas having a temperature difference of approximately 2°C.

12. Gas pipe system according to one of Claims 1 to 11, **characterized in that** the first evaporator (31) and the carrier gas source (27) are connected to one another via at least one pipe (48), **in that** the second evaporator (32) and the gas source (26) are connected to one another via at least one further pipe (62, 68), and **in that** the pipe (48) and the further pipe (48, 62, 68) have a diameter which is smaller than the diameter of the first and second heated pipes (34, 35, 36, 37).

13. Gas pipe system according to Claim 12, **characterized in that** the diameter of the pipe (48) and of the further pipe (48, 62, 68) is not more than 6 mm.

14. Gas pipe according to one of the preceding claims, **characterized in that** the gas from the carrier gas source (27) is nitrogen ($N_2$).

15. Gas pipe according to one of the preceding claims, **characterized in that** the gas from the gas source (26) is an inert gas, preferably helium.

16. Gas pipe system according to one of the preceding claims, **characterized in that** the first evaporator (31) is a bubbler-type evaporator (31) and contains liquid TEAS, and the second evaporator (32) contains liquid TEOS.

17. Gas pipe system according to one of the preceding claims, **characterized in that**

- the process reactor (10) has a process tube (12) in which a tubular liner (13) and a base (14) for semiconductor substrates (19) are arranged,
- a flange (15) is provided, which is connected to the process tube (12),
- a gas inlet (16) and a gas outlet (17) are provided on the process reactor, and
- the gas inlet (16) is respectively connected via the first and second heated pipes (34, 35, 36, 37) to the first and second evaporators (31, 32).

18. Gas pipe system according to Claim 17, **characterized in that** the gas inlet (16) and/or the gas outlet (17) are/is arranged in the flange (15).

19. Gas pipe system according to Claim 17 or 18, **characterized in that** the gas inlet (16) has at least two gas inlet openings (16a, 16b), with one gas inlet opening (16a) being connected to the second evaporator (32), and the other gas inlet opening (16b) being connected to the first evaporator (31).

20. Gas pipe system according to one of Claims 17 to 19, **characterized in that** a heating/cooling apparatus (25) is arranged on the flange (15).

21. Gas pipe system according to one of Claims 17 to 20, **characterized in that** the base (14) is designed to accommodate more than 100 semiconductor substrates (19), preferably approximately 150 semiconductor substrates (19).

**22.** Method for depositing an As-doped SiO$_2$ layer on semiconductor substrates, **characterized by** the following steps:

- fitting a process reactor (10), which has a process tube (12) and a flange (15), with a large number of semiconductor substrates (19) to be treated, with the semiconductor substrates (19) being introduced into the process tube;
- heating the process reactor (10) to a temperature of 450 to 1250°C, preferably 600 to 700°C;
- heating the flange via a heating/cooling apparatus (25) arranged on the flange, with the heating/cooling apparatus (25) containing a medium which is at a temperature of more than 90°C;
- introducing TEOS (tetraethylorthosilicate) and TEAS (triethylarsenate) into the process reactor (10) in order to deposit the As-doped SiO$_2$ layer, with TEAS being introduced via at least one first heated pipe (34, 35) from a first evaporator (31) which contains liquid TEAS, and TEOS being introduced via at least one second heated pipe (36, 37) from a second evaporator (32) which contains liquid TEAS;
- depositing the As-doped SiO$_2$ layer on the semiconductor substrates (19).

**23.** Method according to Claim 22, **characterized in that** a pressure of 20 to 100 Pa, preferably 66.6 ± 13.3 Pa is set in the process reactor (10).

**24.** Method according to Claim 22 or 23, **characterized in that** the liquid TEAS in the first evaporator (31) is set to a constant temperature of between 25°C and 90°C, preferably of between 30°C and 50°C, with an accuracy of ± 0.5°C.

**25.** Method according to one of Claims 22 to 24, **characterized in that** the liquid TEOS in the second evaporator (32) is set to a constant temperature of between 25°C and 90°C, preferably of between 25°C and 35°C, with an accuracy of ± 0.5°C.

**26.** Method according to one of Claims 22 to 25, **characterized in that** the TEOS flow is set via the TEOS vaporization temperature in the second evaporator (32).

**27.** Method according to one of Claims 22 to 26, **characterized in that** TEAS is vaporized by blowing an inert gas, preferably nitrogen gas (N$_2$), through the liquid TEAS in the first evaporator (31).

**28.** Method according to one of Claims 23 to 27, **characterized in that** the TEAS flow is adjusted via the temperature in the first evaporator (31) and the flow of the carrier gas.

**29.** Method according to Claim 28, **characterized in that** the flow of the carrier gas is 50 to 200 standard cubic centimetres per minute (sccm).

**30.** Method according to one of Claims 22 to 29, **characterized in that** the deposition time, temperature and pressure in the process reactor, vaporization rate of TEAS and TEOS as well as the TEAS/TEOS ratio are matched to one another such that an As-doped SiO$_2$ layer with a thickness of approximately 150 nm is deposited.

**31.** Method according to one of Claims 22 to 30, **characterized in that** the deposited As-doped SiO$_2$ layer has an arsenic content of 5.5 ± 2.5%.

**Revendications**

**1.** Réseau de conduites de gaz pour un réacteur où s'effectue des opérations et destiné au traitement de substrats semi-conducteurs, comportant

- un premier évaporateur (31) destiné à évaporer du TEAS (arséniate de triéthyle), qui côté entrée communique avec une source de gaz porteur (27) et côté sortie comporte au moins une première conduite chauffée (34, 35), qui assure la communication entre le premier évaporateur (31) et un réacteur (10), et
- un deuxième évaporateur (32), destiné à évaporer du TEOS (orthosilicate de tétraéthyle), qui côté entrée communique avec une source de gaz (36) et côté sortie comporte au moins une deuxième conduite chauffée (36, 37) destinée à assurer une communication entre le deuxième évaporateur et le réacteur (10).

**2.** Réseau de conduites de gaz selon la revendication 1, **caractérisé en ce qu'**entre le deuxième évaporateur (32) et la source de gaz (26) est disposé un réservoir à liquide (33), rempli de TEOS.

3. Réseau de conduites de gaz selon la revendication 1 ou 2, **caractérisé en ce que** le premier évaporateur (31) comporte au moins un premier régulateur de température (28) destiné à réguler la température dans le premier évaporateur (31).

4. Réseau de conduites de gaz selon l'une des revendications 1 à 3, **caractérisé en ce que** le deuxième évaporateur (32) comporte au moins un deuxième régulateur de température (29) destiné à réguler la température dans le deuxième évaporateur (32).

5. Réseau de conduites de gaz selon l'une des revendications précédentes, **caractérisé en ce que** le premier régulateur de température (28) et le deuxième régulateur de température (29) présentent dans la plage située entre 25 et 90°C une précision de réglage de $\pm$ 0,5°C.

6. Réseau de conduites de gaz selon l'une des revendications précédentes, **caractérisé en ce que** les premières et les deuxièmes conduites chauffées (34, 35, 36, 37) ont un diamètre supérieur à 6 mm, de préférence un diamètre de 12 mm.

7. Réseau de conduites de gaz selon l'une des revendications précédentes, **caractérisé en ce que** chacune des premières et deuxièmes conduites chauffées (34, 35, 36, 37) est chauffée par un traceur (80, 81).

8. Réseau de conduites de gaz selon la revendication 7, **caractérisé en ce que** les traceurs (80, 81) permettent d'ajuster une température constante pour chacune des premières et deuxièmes conduites chauffées (34, 35, 36, 37).

9. Réseau de conduites de gaz selon la revendication 1, **caractérisé en ce que** chacun des traceurs (80, 81) est subdivisé en plusieurs secteurs, la température de chaque secteur pouvant être ajustée d'une manière individuelle de façon que les premières et deuxièmes conduites chauffées (34, 35, 36, 37) aient des températures différentes, correspondant aux secteurs des traceurs (80, 81).

10. Réseau de conduites de gaz selon la revendication 9, **caractérisé en ce que**, en partant du premier et/ou du deuxième évaporateur (31, 32), et en allant vers le réacteur (10), la température du secteur immédiatement suivant est supérieure à la température du secteur précédent.

11. Réseau de conduites de gaz selon la revendication 10, **caractérisé en ce que** chacun des traceurs est subdivisé en quatre secteurs, les secteurs contigus présentant une différence de température d'environ 2°C.

12. Réseau de conduites de gaz selon l'une des revendications 1 à 11, **caractérisé en ce que** le premier évaporateur (31) et la source de gaz porteur (27) communiquent l'un avec l'autre par au moins une conduite (48), que le deuxième évaporateur (32) et la source de gaz (26) communiquent l'un avec l'autre par au moins une autre conduite (62, 68), et que la conduite (48) et l'autre conduite (48, 62, 68) ont un diamètre qui est inférieur au diamètre des premières et deuxièmes conduites chauffées (34, 35, 36, 37).

13. Réseau de conduites de gaz selon la revendication 12, **caractérisé en ce que** le diamètre de la conduite (48) et de l'autre conduite (48, 62, 68) est inférieur ou égal à 6 mm.

14. Conduites de gaz selon l'une des revendications précédentes, **caractérisées en ce que** le gaz de la source de gaz porteur (27) est l'azote ($N_2$).

15. Conduites de gaz selon l'une des revendications précédentes, **caractérisées en ce que** le gaz de la source de gaz (26) est un gaz inerte, de préférence l'hélium.

16. Réseau de conduites de gaz selon l'une des revendications précédentes, **caractérisé en ce que** le premier évaporateur (31) est un évaporateur à bulles (31), et contient du TEAS liquide, et le deuxième évaporateur (32) contient du TEOS liquide.

17. Réseau de conduites de gaz selon l'une des revendications précédentes, **caractérisé en ce que**

- le réacteur (10) comporte un tube (12) où s'effectue des opérations et dans lequel sont disposés un manchon tubulaire (13) ainsi qu'un support (14) pour des substrats semi-conducteurs (19),
- on prévoit une bride (15), reliée au tube (12),
- on prévoit une admission des gaz (16) et une sortie des gaz (17) sur le réacteur, et
- l'admission des gaz (16) communique, par la première et la deuxième conduites chauffées (34, 35, 36, 37), respectivement avec le premier et le deuxième évaporateurs (31, 32).

18. Réseau de conduites de gaz selon la revendication 17, **caractérisé en ce que** l'admission des gaz (16) et/ou la sortie des gaz (17) sont disposées dans la bride (15).

19. Réseau de conduites de gaz selon la revendication 17 ou 18, **caractérisé en ce que** l'admission des gaz (16) comporte au moins deux orifices d'entrée du gaz (16a, 16b), un orifice d'entrée du gaz (16a) communiquant avec le deuxième évaporateur (32) et l'autre orifice d'entrée du gaz (16b) communiquant avec le premier évaporateur (31).

20. Réseau de conduites de gaz selon l'une des revendications 17 à 19, **caractérisé en ce qu'**un dispositif de chauffage/refroidissement (25) est disposé contre la bride (15).

21. Réseau de conduites de gaz selon l'une des revendications 17 à 20, **caractérisé en ce que** le support (14) est configuré de façon à recevoir plus de 100 substrats semi-conducteurs (19), de préférence environ 150 substrats semi-conducteurs (19).

22. Procédé pour déposer une couche de $SiO_2$ dopée à l'As sur des substrats semi-conducteurs, **caractérisé par** les étapes suivantes :

- garnissage d'un réacteur (10) comportant un tube (12) où s'effectue des opérations et une bride (15), d'un grand nombre de substrats semi-conducteurs (19) devant être traités, les substrats semi-conducteurs (19) étant introduits dans le tube ;
- chauffage du réacteur (10) à une température de 450 à 1250°C, de préférence de 600 à 700°C ;
- chauffage de la bride à l'aide d'un dispositif de chauffage/refroidissement (25) disposé contre la bride, le dispositif de chauffage/refroidissement (25) contenant un fluide ayant une température supérieure à 90°C ;
- introduction de TEOS (orthosilicate de tétraéthyle) et de TEAS (arséniate de triéthyle) dans le réacteur (10) pour déposer la couche de $SiO_2$ dopée à l'As, le TEAS étant introduit par au moins une première conduite chauffée (34, 35) à partir d'un premier évaporateur (31) contenant du TEAS liquide, et le TEOS étant introduit par au moins une deuxième conduite chauffée (36, 37) à partir d'un deuxième évaporateur (32) qui contient du TEAS liquide ;
- dépôt, sur les substrats semi-conducteurs (19), de la couche de $SiO_2$ dopée à l'As.

23. Procédé selon la revendication 22, **caractérisé en ce qu'**une pression de 20 à 100 Pa, de préférence de 66,6 ± 13,3 Pa, est ajustée dans le réacteur industriel (10).

24. Procédé selon la revendication 22 ou 23, **caractérisé en ce que** le TEAS liquide est, dans le premier évaporateur (31), ajusté à une température constante comprise entre 25 et 90°C, de préférence entre 30 et 50°C, avec une précision de ± 0,5°C.

25. Procédé selon l'une des revendications 22 à 24, **caractérisé en ce que** le TEOS liquide est, dans le deuxième évaporateur (32), ajusté à une température constante comprise entre 25 et 90°C, de préférence entre 25 et 35°C, avec une précision de ± 0,5°C.

26. Procédé selon l'une des revendications 22 à 25, **caractérisé en ce que** le débit du TEOS est ajusté dans le deuxième évaporateur (32) par la température d'évaporation du TEOS.

27. Procédé selon l'une des revendications 22 à 26, **caractérisé en ce que** le TEAS est évaporé par insufflation d'un gaz inerte, de préférence de l'azote gazeux ($N_2$) dans le TEAS liquide dans le premier évaporateur (31).

28. Procédé selon l'une des revendications 23 à 27, **caractérisé en ce que** le débit du TEAS est ajusté par la température dans le premier évaporateur (31) et le débit du gaz porteur.

29. Procédé selon la revendication 28, **caractérisé en ce que** le débit du gaz porteur est de 50 à 200 centimètres cubes normaux par minute (Ncm$^3$/min).

30. Procédé selon l'une des revendications 22 à 29, **caractérisé en ce que** le temps de dépôt, la température et la pression dans le réacteur industriel, la vitesse d'évaporation du TEAS et du TEOS, ainsi que le rapport TEAS/ TEOS, sont adaptés l'un à l'autre de façon à déposer une couche de $SiO_2$ dopée à l'As ayant une épaisseur d'environ 150 nm.

31. Procédé selon l'une des revendications 22 à 30, **caractérisé en ce que** la couche de $SiO_2$ dopée à l'As telle que déposée a une teneur en arsenic de 5,5 % ± 2,5 %.

**FIG 1**

Abluft

N₂

He

FIG 2

FIG 3

FIG 4

EP 1 007 761 B1

FIG 5